# EUROPEAN PATENT SPECIFICATION

(11) **EP 3 062 441 B1**
(45) Date of publication and mention of the grant of the patent: **05.06.2019**
(21) Application number: 14855594.9
(22) Date of filing: 20.06.2014
(51) Int. Cl.: H03H 9/17, H03H 3/04, H03H 3/02

(54) **THIN-FILM RESONATOR MANUFACTURING METHOD AND DEVICE**
DÜNNSCHICHTRESONATORHERSTELLUNGSVERFAHREN UND -VORRICHTUNG
DISPOSITIF ET PROCÉDÉ DE FABRICATION DE RÉSONATEUR À COUCHES MINCES

(30) Priority: 23.10.2013 CN 201310501329
(43) Date of publication of application: 31.08.2016
(73) Proprietor: ZTE Corporation, Shenzhen, Guangdong 518057 (CN)
(72) Inventor: ZHANG, Hao, Shenzhen Guangdong 518057 (CN); DU, Liangzhen, Shenzhen Guangdong 518057 (CN); PANG, Wei, Shenzhen Guangdong 518057 (CN); CHENG, Wei, Shenzhen Guangdong 518057 (CN); JIANG, Yuan, Shenzhen Guangdong 518057 (CN); SUN, Hailong, Shenzhen Guangdong 518057 (CN)
(74) Representative: Novagraaf Technologies
(86) International application number: PCT/CN2014/080442
(87) International publication number: WO 2015/058541

(56) References cited:
- WO-A1-2007/140943
- CN-A- 101 361 266
- US-A1- 2004 001 913
- US-A1- 2004 017 130
- US-A1- 2004 200 049
- US-A1- 2004 239 450
- US-A1- 2008 309 432
- US-A1- 2012 201 954
- US-B1- 6 339 276

## Description

### Technical Field

The present disclosure relates to the field of electronic technology, and in particular to a method and device for manufacturing a film resonator.

### Background

A film piezoelectric bulk acoustic resonator utilizing the longitudinal resonance of a piezoelectric film in the thickness direction has become a viable alternative for a surface acoustic wave device and a quartz crystal resonator in various aspects such as mobile communications, high-speed serial data application and the like. A radio frequency front-end bulk acoustic piezoelectric filter/duplexer can provide an excellent filtering performance, for example, a low-insertion loss, a steep filter strip, a larger power capacity, and a stronger Electrostatic Discharge (ESD) resisting capability. A high-frequency film piezoelectric bulk acoustic oscillator with an ultra-low frequency and temperature drift is low in phase noise, low in power consumption and large in bandwidth modulation range. In addition, these micro film piezoelectric bulk acoustic resonators use the processing technology which is compatible with a Complementary Metal Oxide Semiconductor (CMOS) on a silicon substrate, and this can reduce the unit cost of device, and is beneficial for integrating with a CMOS circuit finally.

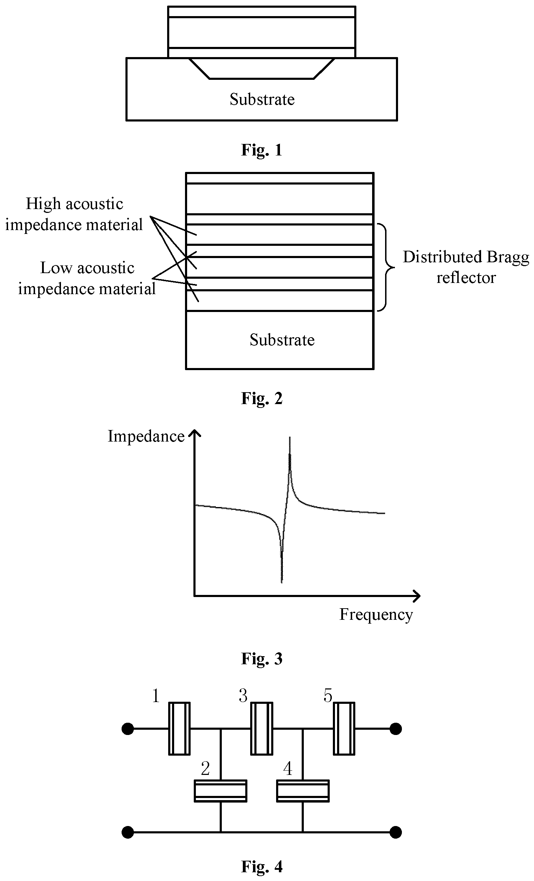

A typical film piezoelectric bulk acoustic resonator includes two metal electrodes, piezoelectric materials between top and bottom electrodes, and an acoustic reflection structure under the bottom electrode. Fig. 1 shows a sectional view of a bulk acoustic resonator which takes a cavity on substrate as the acoustic reflection structure. The acoustic wave will generate a good reflection on an interface between the bottom electrode and the air in the cavity. Fig. 2 shows a sectional view of a bulk acoustic resonator which takes a distributed Bragg reflector as the acoustic reflection structure. The acoustic wave reflection effect provided by high and low acoustic impedance materials which are arranged alternately is weaker than that generated by a cavity reflection structure; but the distributed Bragg reflector is easy to be manufactured and stable in structure. When a voltage signal with a certain frequency is applied between the electrodes, because of the converse piezoelectric effect of the piezoelectric materials, the acoustic wave propagating in vertical direction will be generated between the electrodes, and the acoustic wave inter-reflects between the acoustic reflection structure and the interface between the top electrode and the air under the bottom electrode; when a certain frequency condition is met, the acoustic wave will resonate, so a typical film piezoelectric bulk acoustic resonator exhibits an electrical frequency-impedance characteristic shown in Fig. 3.

A filter composed of the film piezoelectric bulk acoustic resonators is usually composed of two or several resonators with different resonance frequencies. In order to achieve ideal band-pass performance of the filter, a resonance frequency offset between the different frequency resonators has a strict requirement. Fig. 4 shows a topological structure instance of a filter composed of the film piezoelectric bulk acoustic resonators. In order to achieve the best band-pass performance of the filter, the frequency of parallel resonators 2, 4 is lower than that of serial resonators 1, 3 and 5. A method for adjusting the resonance frequency of the film piezoelectric bulk acoustic resonator adopted in the related art is adjusting the thickness of the electrode to cause the change of the electrode quality, so that a mass loading effect is generated to cause the change of the resonance frequency of the resonator. By depositing a mass loading layer with a certain thickness on the specified resonator, the required resonance frequency offset can be generated, and a relationship between the frequency offset and the thickness of the mass loading layer which needs to be increased can be calculated through a model.

However, in the practical manufacturing process, an error of thickness inevitably exists in the deposition of a film, especially in the deposition of a film with a larger thickness. During monitoring the film deposition of product, the thickness of each deposited film layer is usually monitored; when it is detected that the thickness of a certain film layer which has been deposited deviates from the ideal value and exceeds a certain range, for guaranteeing the yield rate of products and enabling the frequency of the final product to meet the design requirements, compensation will be conducted for the thickness of the film layer to be deposited. However, the thickness of each film layer on the acoustic reflection structure has a certain affect on the resonance frequency of the resonator; because the acoustic wave transmission characteristics of different layers are different, after a thickness proportion between the different layers changes, the mass loading layer with the same thickness usually cannot make the resonator achieve the originally designed resonance frequency offset, so the resonator on which film layer thickness compensation has been conducted cannot generate the ideal frequency offset under the original thickness of the mass loading layer, and the bandwidth and band-pass performance of the filter cannot meet requirements, which affects the yield rate of products.

### Summary

The main technical problem to be solved by the embodiments of the present disclosure is to provide a method and device for manufacturing a film resonator, which can accurately generate the required frequency offset, thereby improving the yield rate of products.

For solving the above technical problem, the embodiments of the present disclosure provide a method for manufacturing a film resonator, which includes: predetermining a filter structure with a plurality of film layers to be deposited and a mass loading layer to be deposited, predetermining a standard thickness range for each film layer to be deposited, predetermining a base frequency of the film resonator without the mass load layer and a target frequency of the film resonator with the mass load layer, predetermining a target frequency offset as the base frequency to the target frequency; detecting a thickness of each film layer which has been deposited; when the detected thickness of any film layer which has been deposited is not in its standard thickness range, judging whether the mass loading layer has been deposited, and in a case that the mass loading layer has not been deposited, selecting for thickness compensation at least one film layer which has not been deposited from the plurality of film layers to be deposited; recalculating, in a model simulation of the filter structure, a compensated thickness of the selected at least one film layer which has not been deposited by substituting the target frequency and the thickness of the film layer which has been deposited into the model, wherein the compensated thickness is determined so that the target frequency is kept unchanged; calculating, in a model simulation of the filter structure, a new calculated thickness of the mass loading layer required for generating the target frequency offset by substituting the compensated thickness of the selected at least one film layer which has not been deposited and the target frequency offset into the model; and conducting subsequent film deposition so that the selected at least one film layer which has not been deposited is deposited with the compensated thickness and the mass loading layer is deposited with new calculated thickness of the mass loading layer.

In an exemplary embodiment, the method may further include that: in a case that the mass loading layer has been deposited, while keeping the base frequency unchanged, selecting different film layers which have not been deposited for thickness compensation, determining a film layer thickness compensation which least affects a frequency offset, and conducting subsequent film deposition according to the determined film layer thickness compensation; wherein selecting different film layers which have not been deposited for thickness compensation, and determining the film layer thickness compensation which least affects the frequency offset comprises: simulating the thickness compensation conducted for each film layer which has not been deposited; calculating the frequency offset after the thickness compensation corresponding to each film layer which has not been deposited; and comparing the frequency offset after the thickness compensation corresponding to each film layer which has not been deposited with the target frequency offset, and determining the film layer thickness compensation having a minimum deviation from the target frequency offset.

In an exemplary embodiment, after the film layer thickness compensation which least affects the frequency offset is determined, and before the subsequent film deposition is conducted according to the determined film layer thickness compensation, the method may further include that:
the determined film layer thickness compensation is evaluated, when an evaluation result meets a preset condition, the subsequent film deposition is conducted according to the determined film layer thickness compensation.

In an exemplary embodiment, the step of evaluating the determined film layer thickness compensation, and when the evaluation result meets the preset condition, conducting subsequent film deposition according to the determined film layer thickness compensation may include that:
it is evaluated whether a minimum deviation from the target frequency offset obviously affects performance of a filter, when the minimum deviation from the target frequency offset does not obviously affect the performance of the filter, it is determined that the preset condition is met, and the subsequent film deposition is conducted according to the determined film layer thickness compensation;
wherein the filter is composed of at least two resonators.

For solving the above technical problem, the embodiments of the present disclosure also provide a device for manufacturing a film resonator, which includes a detecting component, a judging component, a processing component and a film depositing component; wherein the device is configured to predetermine a filter structure with a plurality of film layers to be deposited and a mass loading layer to be deposited, predetermine a standard thickness range for each film layer to be deposited, predetermine a base frequency of the film resonator without the mass load layer and a target frequency of the film resonator with the mass load layer, and predetermine a target frequency offset as the base frequency to the target frequency; the detecting component is configured to detect a thickness of each film layer which has been deposited; the judging component is configured to, when the detected thickness of any film layer which has been deposited is not in its standard thickness range, judge whether the mass loading layer has been deposited; the processing component is configured to, in a case that a judgement result of the judging component is that the mass loading layer has not been deposited, select for thickness compensation at least one film layer which has not been deposited from the plurality of film layers to be deposited, recalculate, in a model simulation of the filter structure, a compensated thickness of the selected at least one film layer which has not been deposited by substituting the target frequency and the thickness of the film layer which has been deposited into the model, wherein the compensated thickness is determined so that the target frequency is kept unchanged, and calculate, in a model simulation of the filter structure, a new calculated thickness of the mass loading layer required for generating the target frequency offset by substituting the compensated thickness of the selected at least one film layer which has not been deposited and the target frequency offset into the model; and the film depositing component is configured to conduct subsequent film deposition so that the selected at least one film layer which has not been deposited is deposited with the compensated thickness and the mass loading layer is deposited with new calculated thickness of the mass loading layer.

In an exemplary embodiment, the processing component is further configured to, in a case that the judgement result of the judging component is that the mass loading layer has been deposited, while keeping the base frequency unchanged, select different film layers which have not been deposited for thickness compensation, and determine the film layer thickness compensation which least affects a frequency offset; the film depositing component is further configured to conduct subsequent film deposition according to the determined film layer thickness compensation; wherein the processing component is configured to simulate the thickness compensation conducted for each film layer which has not been deposited, calculate the frequency offset after the thickness compensation corresponding to each film layer which has not been deposited, compare the frequency offset after the thickness compensation corresponding to each film layer which has not been deposited with the target frequency offset, and determine the film layer thickness compensation having a minimum deviation from the target frequency offset.

In an exemplary embodiment, the device further includes: an evaluating component;
the evaluating component is configured to, after determining the film layer thickness compensation which least affects the frequency offset, and before conducting subsequent film deposition according to the determined film layer thickness compensation, evaluate the determined film layer thickness compensation, and when the evaluation result meets the preset condition, inform the film depositing component to conduct subsequent film deposition according to the determined film layer thickness compensation.

In an exemplary embodiment, the evaluating component is configured to evaluate whether the minimum deviation from the target frequency offset obviously affects the performance of the filter, when the minimum deviation from the target frequency offset does not obviously affect the performance of the filter, determine that the preset condition is met, and inform the film depositing component to conduct subsequent film deposition according to the determined film layer thickness compensation; wherein the filter is composed of at least two resonators.

The beneficial effect of the embodiments of the present disclosure is that:
the embodiments of the present disclosure provide a method and device for manufacturing a film resonator, which can accurately generate the required frequency offset, thereby improving the yield rate of products. The manufacturing method of the embodiments of the present disclosure includes that: the thickness of each film layer which has been deposited is detected; when the detected thickness of any film layer which has been deposited is not in the standard thickness range, it is judged whether the mass loading layer has been deposited, and when the mass loading layer has not been deposited, at least one film layer which has not been deposited is selected for thickness compensation, and according to a compensated thickness of the selected at least one film layer which has not been deposited and the target frequency offset, a thickness of the mass loading layer required for generating the target frequency offset is calculated, wherein the standard thickness range is determined by the target frequency and a process production capacity of the resonator; and subsequent film deposition is conducted according to the compensated thickness of the selected at least one film layer which has not been deposited and the calculated thickness of the mass loading layer. The manufacturing method of the embodiments of the present disclosure can conduct thickness correction for the film layer which has not been manufactured when the thickness of a certain film layer exceeds a set standard in the manufacturing process, and recalculate a thickness of the mass loading layer under a condition that the whole frequency of the resonator does not deviate from a target value, so that the required frequency offset is accurately generated on the specified resonator. This method does not need additional technique processes added; compared with the related art, the manufacturing method of the present disclosure can save the manufacture cost while improving the yield rate of products.

### Brief Description of the Drawings

Fig. 1 shows a structure diagram of a film piezoelectric bulk acoustic resonator which takes a cavity on substrate as an acoustic reflection structure;
Fig. 2 shows a structure diagram of a film piezoelectric bulk acoustic resonator which takes a distributed Bragg reflector as the acoustic reflection structure;
Fig. 3 shows an impedance frequency curve of a film piezoelectric bulk acoustic resonator;
Fig. 4 shows a topological structure diagram of a filter;
Fig. 5 shows a flowchart of a method for manufacturing a film resonator provided by an implementation example 1 of the present disclosure;
Fig. 6 shows a structure diagram of a film piezoelectric bulk acoustic resonator provided by the implementation example 1 of the present disclosure;
Fig. 7 shows a flowchart of another method for manufacturing a film resonator provided by the implementation example 1 of the present disclosure;
Fig. 8 shows a structure diagram of a film piezoelectric bulk acoustic resonator provided by an implementation example 2 of the present disclosure;
Fig. 9 shows a flowchart of a film piezoelectric bulk acoustic resonator manufacturing method provided by the implementation example 2 of the present disclosure;
Fig. 10 shows a structure diagram of a film piezoelectric bulk acoustic resonator provided by an implementation example 3 of the present disclosure;
Fig. 11 shows a flowchart of a film piezoelectric bulk acoustic resonator manufacturing method provided by the implementation example 3 of the present disclosure;
Fig. 12 shows a structure diagram of a device for manufacturing a film resonator provided by an implementation example 4 of the present disclosure; and
Fig. 13 shows a structure diagram of another device for manufacturing a film resonator provided by the implementation example 4 of the present disclosure.

### Detailed Description of the Embodiments

The present disclosure is further elaborated below in combination with the accompanying drawings and specific Implementation Example.

### Implementation Example 1

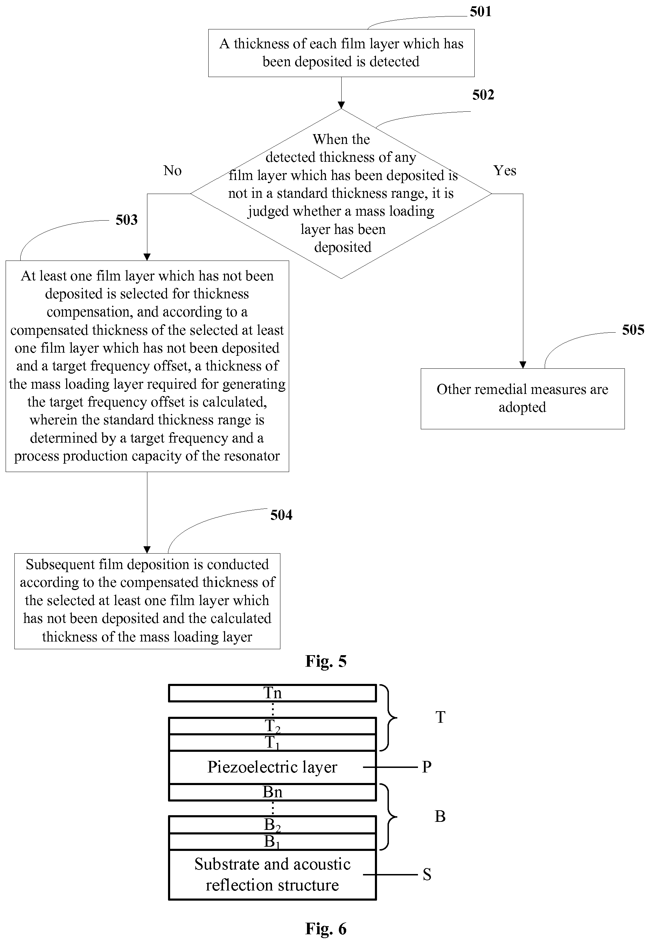

As shown in Fig. 5, the present implementation example provides a method for manufacturing a film resonator, which includes:
Step 501: a thickness of each film layer which has been deposited is detected;
Step 502: when the detected thickness of any film layer which has been deposited is not in a standard thickness range, it is judged whether a mass loading layer has been deposited; when the mass loading layer has not been deposited, perform Step 503; or else, perform Step 505;
Step 503: at least one film layer which has not been deposited is selected for thickness compensation, and according to a compensated thickness of the selected at least one film layer which has not been deposited and a target frequency offset, a thickness of the mass loading layer required for generating the target frequency offset is calculated, wherein the standard thickness range is determined by a target frequency and a process production capacity of the resonator;
Step 504: subsequent film deposition is conducted according to the compensated thickness of the selected at least one film layer which has not been deposited and the calculated thickness of the mass loading layer;
Step 505: other remedial measures are adopted.

The manufacturing method of the present implementation example can conduct thickness correction for the film layer which has not been manufactured when the thickness of a certain film layer exceeds a set standard in the manufacturing process, and recalculate a thickness of the mass loading layer under a condition that the whole frequency of the resonator does not deviate from a target value, so that the required frequency offset is accurately generated on the specified resonator. This method does not need additional technique processes added; compared with the related art, the manufacturing method of the present implementation example can save the manufacture cost while improving the yield rate of products. The standard thickness range in the present implementation example may be determined by the target frequency, and it can be further determined by considering both the process capability and the required frequency accuracy of product.

Fig. 6 shows a film piezoelectric bulk acoustic resonator which is manufactured by using the manufacturing method in the present implementation example. The film layer S may be either a structure composed of a substrate and a distributed Bragg reflector which is formed by depositing high and low acoustic impedance materials alternately, or a structure composed of a substrate and a sacrificial layer material. After the sacrificial layer material is removed, an air-filled cavity structure is formed under a bottom electrode, thereby providing an excellent acoustic reflection efficiency. The substrate may be silicon; the high and low acoustic impedance materials may be respectively Wolfram (W) and Silicon Oxide (SiO2) or other two materials with a large acoustic impedance ratio. The sacrificial layer may be Phosphate Silicon Glass (PSG) or other materials which are easy to be removed. The film layer B is above the substrate and the acoustic reflection structure; the film layer B should include a bottom metal electrode, and may also include other film layers, e.g., a temperature compensation layer formed by the SiO2 and the mass loading layer which is set for generating the frequency offset, and so on. A piezoelectric layer P is above the film layer B, and the piezoelectric layer P may be formed by Aluminium Nitride (AlN), Zinc Oxide (ZnO) or Lead Zirconate Titanate (PZT) or other suitable piezoelectric materials. The film layer T is above the piezoelectric layer P; the film layer T should include a top metal electrode, and may also include the temperature compensation layer formed by the SiO2, the mass loading layer which is set for generating the frequency offset, a surface passivation layer for preventing a device from oxidation, and so on. The bottom electrode and the top electrode may be formed by Molybdenum (Mo), Wolfram (W) or other metal materials; the mass loading layer for generating a certain frequency offset may be formed by the same material as the top electrode or different material as needed; the mass loading layer M for generating the required frequency offset is located at a certain layer of the film layer group T or B; the frequency offset is defined as f1-f2, wherein f1 is an electrical resonance frequency of a device after the mass loading layer M is removed from the current structure, and f2 is the electrical resonance frequency of the device of the current structure including the mass loading layer M.

The manufacturing method of the present implementation example may further include that: when the mass loading layer has been deposited, while keeping a base frequency of the resonator unchanged, different film layers which have not been deposited are selected for thickness compensation, a film layer thickness compensation which least affects a frequency offset is determined, and the subsequent film deposition is conducted according to the determined film layer thickness compensation.

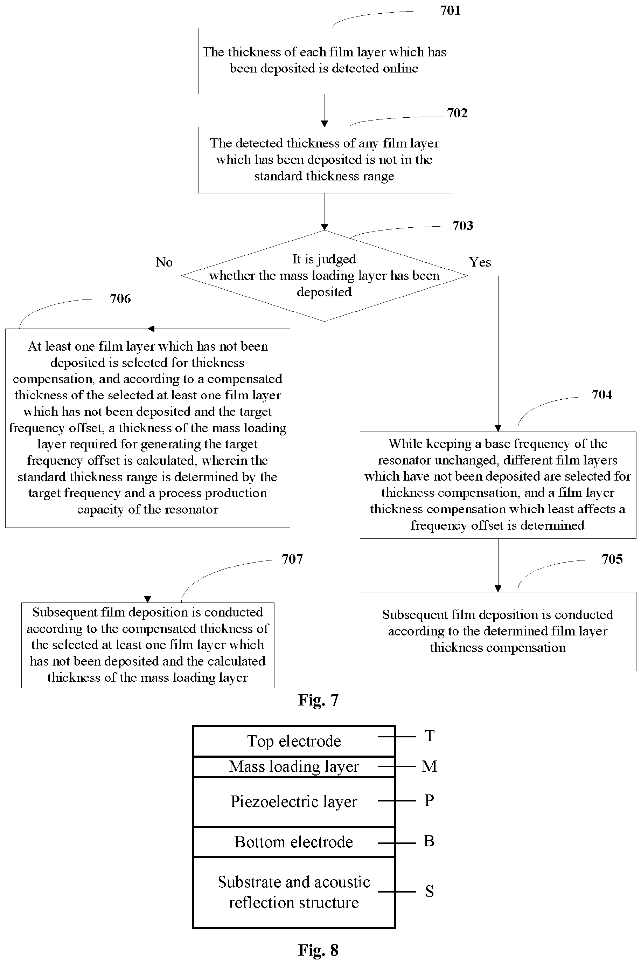

As shown in Fig. 7, the manufacturing method of the present implementation example may include the following steps:
Step 701: a thickness of each film layer which has been deposited is detected online;
Step 702: the detected thickness of at least one film layer which has been deposited is not in the standard thickness range;
Step 703: it is judged whether the mass loading layer has been deposited; if so, perform Step 704; or else, perform Step 706;
Step 704: while keeping a base frequency of the resonator unchanged, different film layers which have not been deposited are selected for thickness compensation, and a film layer thickness compensation which least affects a frequency offset is determined;
Step 705: the subsequent film deposition is conducted according to the determined film layer thickness compensation;
Step 706: at least one film layer which has not been deposited is selected for thickness compensation, and according to a compensated thickness of the selected at least one film layer which has not been deposited and the target frequency offset, a thickness of the mass loading layer required for generating the target frequency offset is calculated, wherein the standard thickness range is determined by the target frequency and a process production capacity of the resonator;
Step 707: subsequent film deposition is conducted according to the compensated thickness of the selected at least one film layer which has not been deposited and the calculated thickness of the mass loading layer.

In the manufacturing process, when it is found that the thickness of a certain layer exceeds the set standard under a condition that the mass loading layer has completely formed, the manufacturing method of the present implementation example may select from subsequent film layers which have not been manufactured, through the model simulation, a film layer which least affects the frequency offset for thickness compensation while keeping a base frequency of the resonator unchanged, thereby minimizing the affect of the film layer thickness compensation on the frequency offset in the allowable range.

In Step 704 of the manufacturing method of the present implementation example, the specific process of selecting different film layers which have not been deposited for thickness compensation, and determining the film layer thickness compensation which least affects the frequency offset may include that:
the thickness compensation conducted for each film layer which has not been deposited is simulated;
the frequency offset after the thickness compensation corresponding to each film layer which has not been deposited is calculated; and
the frequency offset after the thickness compensation corresponding to each film layer which has not been deposited is compared with the target frequency offset, and a film layer thickness compensation having a minimum deviation from the target frequency offset is determined.

After Step 704 and before Step 705, the manufacturing method of the present implementation example may further include that: the determined film layer thickness compensation is evaluated, and when an evaluation result meets a preset condition, the subsequent film deposition is conducted according to the determined film layer thickness compensation. In this way, it can be determined whether a result obtained from simulation can meet a design application requirement; if not, it may be needed to adopt additional processing steps to remedy the frequency offset of the resonator. For example, it is possible to evaluate whether the minimum deviation from the target frequency offset obviously affects the performance of the filter; when the minimum deviation from the target frequency offset does not obviously affect the performance of the filter, it is determined that the preset condition is met, and the subsequent film deposition is conducted according to the determined film layer thickness compensation; when the minimum deviation from the target frequency offset obviously affects the performance of the filter, the additional processing steps are adopted to remedy the frequency offset of the resonator, wherein the filter is composed of at least two resonators, refer to the structure of the filter in Fig. 4.

### Implementation Example 2

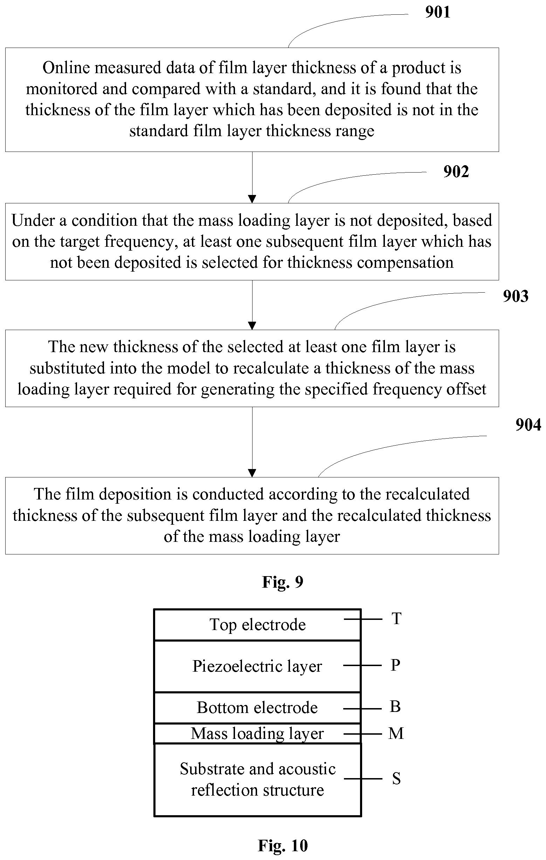

The present implementation example illustrates a method for manufacturing a film resonator in the implementation example 1 by taking manufacturing the film piezoelectric bulk acoustic resonator shown in Fig. 8 for example. As shown in Fig. 9, the process of manufacturing the film piezoelectric bulk acoustic resonator in the present implementation example mainly includes.

Step 901: online measured data of film layer thickness of a product is monitored and compared with a standard, and it is found that the thickness of the film layer which has been deposited is not in the standard film layer thickness range.

In the process of manufacturing the film piezoelectric bulk acoustic resonator, because the technology of depositing or sputtering film cannot keep absolutely stable in production, the thickness of the manufactured film inevitably fluctuates; because the frequency of the film piezoelectric bulk acoustic resonator is affected by the thickness of each film layer on the acoustic reflection structure, online detection should be conducted on the thickness of each film. The online detection may directly detect the thickness on the manufactured product using a step profiler, an ellipsometer and other film layer thickness detecting testers, or may detect the thickness by adding an additional monitoring glass.

The standard film layer thickness range in the present implementation example may be determined by considering both the process capability and the required frequency accuracy of product. If it is found that the film layer thickness detected online exceeds the set standard film layer thickness range, some solutions should be adopted. At this point, it is possible to rework or add some unconventional processes to adjust the film layer thickness of this layer to being in the standard, but this increases the manufacturing processes; as a result, not only manufacture cost is increased, but some unstable factors are brought to affect the yield rate of the final products. Because the resonance frequency of the film piezoelectric bulk acoustic resonator is affected by the thickness of each film layer on the acoustic reflection structure, a preferred solution is to adjust the thickness of the film layer to be manufactured to make the resonance frequency of the final device go back to the standard. For example, in the present implementation example, suppose that the thickness standard of the bottom electrode is set as 3000±100A, it is found during a certain measurement that the thickness of the manufactured bottom electrode is 3200A, which exceeds the standard, so it is needed to conduct the film layer thickness compensation for the subsequent film layer.

Step 902: under a condition that the mass loading layer is not deposited, based on the target frequency, the subsequent film layer which has not been deposited is selected for thickness compensation.

In the manufacturing method of the present implementation example, the piezoelectric layer, the top electrode or other film layers affecting the frequency can be selected. By substituting the target frequency and the thickness of the film layer which has been deposited into a model, the thickness after the selected subsequent film layer thickness compensation is recalculated. For example, in the present implementation example, the top electrode is selected for the film layer thickness compensation, and the original design thickness of the top electrode is 3000A, it is calculated through the model that the thickness of the top electrode needs to be decreased by 200A while keeping the target frequency unchanged, that is, the thickness of the top electrode after compensation is 2800A.

Step 903: the new thickness of the film layer is substituted into the model to recalculate a thickness of the mass loading layer required for generating the specified frequency offset.

For example, in the present implementation example, it is required that the difference between the resonator without the mass loading layer and the resonator with the mass loading layer in the same filter, namely the frequency offset, equals to 20MHz; when the thickness of the top electrode and the bottom electrode is 3000A, the thickness of the mass loading layer is designed as 300A. By substituting the adjusted thickness 2800A of the top electrode and the original thickness 300A of the mass loading layer into the model, the actual frequency offset 22MHz is obtained. So, under a condition that the frequency offset keeps at 20MHz, the thickness of the mass loading layer is calculated to obtain a new thickness 250A of the mass loading layer.

Step 904: the film deposition is conducted according to the calculated thickness of the subsequent film layer and the thickness of the mass loading layer.

After the whole manufacturing process is completed, the base frequency and the frequency offset of the manufactured resonator meet the required frequency. Thus, a filter structure whose performance meets requirements based on the film piezoelectric bulk acoustic resonator can be obtained.

### Implementation Example 3

The present implementation example illustrates the method for manufacturing a film resonator in the implementation example 1 by taking manufacturing the film piezoelectric bulk acoustic resonator shown in Fig. 10 for example. It is defined that f1 is the electrical resonance frequency of the device after the film layer M is removed from the current structure, namely a base resonance frequency, and f2 is the electrical resonance frequency of the device of the current structure including the film layer M, namely the target resonance frequency.

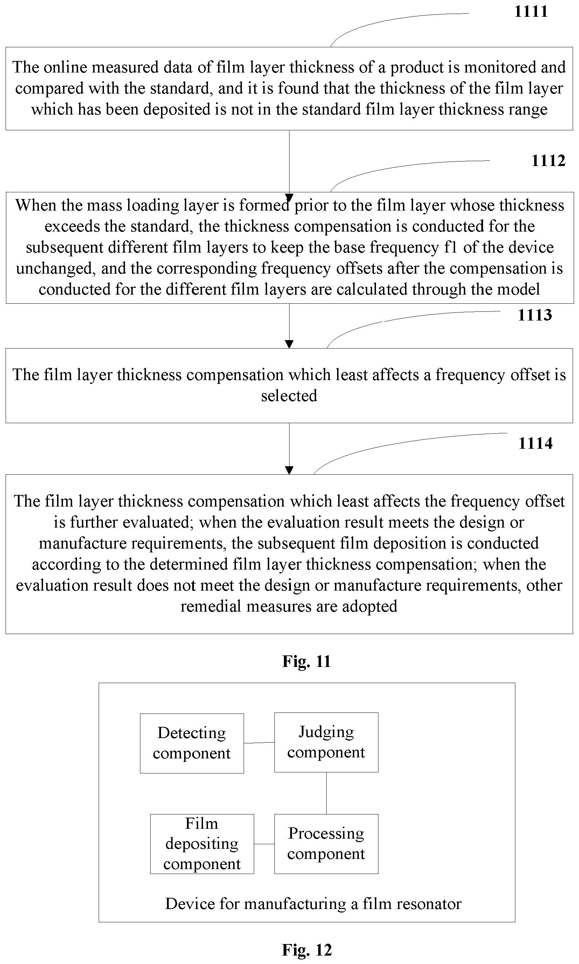

As shown in Fig. 11, the process of manufacturing the film piezoelectric bulk acoustic resonator in the present implementation example mainly includes the following steps.

Step 1111: the online measured data of film layer thickness of a product is monitored and compared with the standard, and it is found that the thickness of the film layer which has been deposited is not in the standard film layer thickness range.

Because the thickness of the film layer exceeding the standard will cause the frequency of the device to deviate from the target value, it is needed to conduct the film layer thickness compensation aiming at the subsequent film layer without adding the additional technique processes, so as to make the base frequency f1 of the final device meet the design requirements. For example, in the present implementation example, the mass loading layer is formed at the lower part of the bottom electrode. It is found through film layer thickness monitoring that the thickness of the bottom electrode is 3200A, which exceeds the monitoring standard 3000±100A, so it is needed to conduct the film layer thickness compensation for the subsequent film layer.

Step 1112: when the mass loading layer is formed prior to the film layer whose thickness exceeds the standard, the thickness compensation is conducted for the subsequent different film layers to keep the base frequency f1 of the device unchanged, and the corresponding frequency offsets after the compensation is conducted for the different film layers are calculated through the model.

The compensated thickness may be calculated by substituting the base frequency f1 and the thickness of the film layer with deviation into the model. For example, in the present implementation example, under a condition that f1 is unchanged, and the thickness of the bottom electrode is 3200A, if the thickness of the top electrode keeps unchanged, it is needed to adjust the thickness of the piezoelectric layer P from 10000A designed before to 9600A, then the generated frequency offset changes from designed 20MHz to 19MHz; if the thickness of the piezoelectric layer is unchanged, it is needed to adjust the thickness of the top electrode from 3000A designed before to 2800A, then the generated frequency offset changes from designed 20MHz to 18MHz.

Step 1113: the film layer thickness compensation which least affects the frequency offset is selected.

For example, in the present implementation example, the difference between the frequency offset generated by the thickness compensation of the piezoelectric layer and a design value 20MHz is 1 MHz, and the difference between the frequency offset generated by the thickness compensation of the top electrode and the design value 20MHz is 2MHz, so the thickness compensation of the piezoelectric layer will be selected for manufacturing the subsequent film layer.

Step 1114: the film layer thickness compensation which least affects the frequency offset is further evaluated; when the evaluation result meets the design or manufacture requirements, the subsequent film deposition is conducted according to the determined film layer thickness compensation; when the evaluation result does not meet the design or manufacture requirements, other remedial measures are adopted.

For example, it is found through simulation that the generated difference 1MHz between the frequency offset corresponding to the selected film layer compensation and the target frequency offset (the design value) will not obviously affect the performance of the filter, that is, the design requirements can be met, so the film layer compensation that the piezoelectric layer is reduced to 9600A and the thickness of the top electrode is unchanged is selected for manufacturing the subsequent film layer.

In the process of manufacturing the resonator, when it is found that the thickness of a certain layer exceeds the set standard under the condition that the mass loading layer has completely formed, the manufacturing method of the present implementation example may select from the subsequent film layers which have not been manufactured, through the model simulation, the film layer which least affects the frequency offset for thickness compensation while keeping a base frequency of the resonator unchanged, thereby minimizing the affect of the film layer thickness compensation on the frequency offset in the allowable range.

The above implementation examples 1 to 3 illustrate the manufacturing method of the present disclosure by taking the film piezoelectric bulk acoustic resonator for example; but the manufacturing method of the present disclosure can also be applied to manufacturing other film resonators.

### Implementation Example 4

As shown in Fig. 12, the present implementation example provides a device for manufacturing a film resonator, which includes: a detecting component, a judging component, a processing component and a film depositing component;
the detecting component is configured to detect a thickness of each film layer which has been deposited;
the judging component is configured to, when the detected thickness of any film layer which has been deposited is not in the standard thickness range, judge whether the mass loading layer has been deposited;
the processing component is configured to, when the judgement result of the judging component is that the mass loading layer has not been deposited, select the film layer which has not been deposited for thickness compensation, and according to a compensated thickness of the selected at least one film layer which has not been deposited and the target frequency offset, calculate a thickness of the mass loading layer required for generating the target frequency offset, wherein the standard thickness range is determined by the target frequency and a process production capacity of the resonator; and
the film depositing component is configured to conduct subsequent film deposition according to the compensated thickness of the selected at least one film layer which has not been deposited and the calculated thickness of the mass loading layer.

In an implementation example, the processing component may be further configured to, when the judgement result of the judging component is that the mass loading layer has been deposited, select different film layers which have not been deposited for thickness compensation, and determine the film layer thickness compensation which least affects a frequency offset;
the film depositing component is further configured to conduct subsequent film deposition according to the determined film layer thickness compensation.

In an implementation example, the processing component may configured to simulate the thickness compensation conducted for each film layer which has not been deposited, calculate the frequency offset after the thickness compensation corresponding to each film layer which has not been deposited, compare the frequency offset after the thickness compensation corresponding to each film layer which has not been deposited with the target frequency offset, and determine the film layer thickness compensation having a minimum deviation from the target frequency offset.

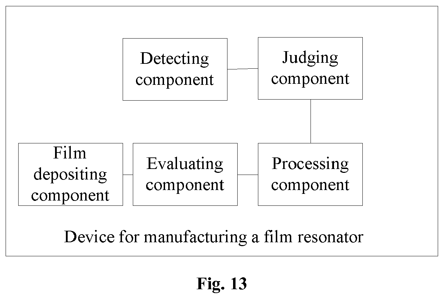

As shown in Fig. 13, the device of the present implementation example further includes: an evaluating component;
the evaluating component is configured to, after determining the film layer thickness compensation which least affects the frequency offset, and before conducting subsequent film deposition according to the determined film layer thickness compensation, evaluate the determined film layer thickness compensation, and when the evaluation result meets the preset condition, inform the film depositing component to conduct subsequent film deposition according to the determined film layer thickness compensation.

In an implementation example, the evaluating component may be configured to evaluate whether the minimum deviation from the target frequency offset obviously affects the performance of the filter, when the minimum deviation from the target frequency offset does not obviously affect the performance of the filter, determine that the preset condition is met, and inform the film depositing component to conduct subsequent film deposition according to the determined film layer thickness compensation, wherein the filter is composed of at least two resonators.

The manufacturing device of the present implementation example can conduct thickness correction for the film layer which has not been manufactured when the thickness of a certain film layer exceeds the set standard in the manufacturing process, and recalculate a thickness of the mass loading layer under the condition that the whole frequency of the resonator does not deviate from a target value, so that the required frequency offset is accurately generated on the specified resonator; this method does not need additional technique processes added; compared with the related art, the manufacturing device of the present implementation example can save the manufacture cost while improving the yield rate of products. Besides, in the process of manufacturing the resonator, when it is found that the thickness of a certain layer exceeds the set standard under the condition that the mass loading layer has completely formed, the manufacturing device of the present implementation example can select from the subsequent film layers which have not been manufactured, through the model simulation, the film layer which least affects the frequency offset for thickness compensation while keeping a base frequency of the resonator unchanged, thereby minimizing the affect of the film layer thickness compensation on the frequency offset in the allowable range.

The above content is a further elaboration of the present disclosure made in combination with the specific implementation examples, and it should not be considered that the specific implementations of the present disclosure are only limited to the elaboration. On the premise of not departing from the conception of the present disclosure, those ordinary skill in the art to which the present disclosure belongs can also make a number of simple deductions and replacements, which shall fall within the scope of the claims of the present disclosure.

### Industrial Applicability

The embodiments of the present disclosure relates to the field of electronic technology. A manufacturing method includes that: a thickness of each film layer which has been deposited is detected; when the detected thickness of any film layer which has been deposited is not in a standard thickness range, it is judged whether a mass loading layer has been deposited, and when the mass loading layer has not been deposited, at least one film layer which has not been deposited is selected for thickness compensation, and according to a compensated thickness of the selected at least one film layer which has not been deposited and a target frequency offset, a thickness of the mass loading layer required for generating the target frequency offset is calculated, wherein the standard thickness range is determined by a target frequency and a process production capacity of the resonator; and the subsequent film deposition is conducted according to the compensated thickness of the selected at least one film layer which has not been deposited and the calculated thickness of the mass loading layer. The manufacturing method of the embodiments of the present disclosure can conduct thickness correction for the film layer which has not been manufactured when the thickness of a certain film layer exceeds a set standard in the manufacturing process, and recalculate a thickness of the mass loading layer under the condition that the whole frequency of the resonator does not deviate from a target value, so that the required frequency offset is accurately generated on the specified resonator. This method does not need additional technique processes; compared with the related art, the manufacturing device of the present disclosure can save the manufacture cost while improving the yield rate of products.

## Claims

1. A method for manufacturing a film resonator, comprising:
predetermining a filter structure with a plurality of film layers to be deposited and a mass loading layer to be deposited,
predetermining a standard thickness range for each film layer to be deposited,
predetermining a base frequency of the film resonator without the mass load layer and a target frequency of the film resonator with the mass load layer,
predetermining a target frequency offset as the base frequency to the target frequency,
the method further comprises:
detecting a thickness of each film layer which has been deposited;
when the detected thickness of any film layer which has been deposited is not in its standard thickness range, judging whether the mass loading layer has been deposited, and in a case that the mass loading layer has not been deposited, selecting for thickness compensation at least one film layer which has not been deposited from the plurality of film layers to be deposited;
recalculating, in a model simulation of the filter structure, a compensated thickness of the selected at least one film layer which has not been deposited by substituting the target frequency and the thickness of the film layer which has been deposited into the model, wherein the compensated thickness is determined so that the target frequency is kept unchanged;
calculating, in a model simulation of the filter structure, a new calculated thickness of the mass loading layer required for generating the target frequency offset by substituting the compensated thickness of the selected at least one film layer which has not been deposited and the target frequency offset into the model; and
conducting subsequent film deposition so that the selected at least one film layer which has not been deposited is deposited with the compensated thickness and the mass loading layer is deposited with new calculated thickness of the mass loading layer.

2. The method as claimed in claim 1, the method further comprising:
in a case that the mass loading layer has been deposited, while keeping the base frequency unchanged, selecting different film layers which have not been deposited for thickness compensation, determining a film layer thickness compensation which least affects a frequency offset, and conducting subsequent film deposition according to the determined film layer thickness compensation;
wherein selecting different film layers which have not been deposited for thickness compensation, and determining the film layer thickness compensation which least affects the frequency offset comprises: simulating the thickness compensation conducted for each film layer which has not been deposited; calculating the frequency offset after the thickness compensation corresponding to each film layer which has not been deposited; and comparing the frequency offset after the thickness compensation corresponding to each film layer which has not been deposited with the target frequency offset, and determining the film layer thickness compensation having a minimum deviation from the target frequency offset.

3. The method as claimed in claim 2, wherein after determining the film layer thickness compensation which least affects the frequency offset, and before conducting the subsequent film deposition according to the determined film layer thickness compensation, the method further comprises:
evaluating the determined film layer thickness compensation, and when an evaluation result meets a preset condition, conducting the subsequent film deposition according to the determined film layer thickness compensation.

4. The method as claimed in claim 3, wherein evaluating the determined film layer thickness compensation, and when the evaluation result meets the preset condition, conducting the subsequent film deposition according to the determined film layer thickness compensation comprises:
evaluating whether the minimum deviation from the target frequency offset obviously affects performance of a filter, when the minimum deviation from the target frequency offset does not obviously affect the performance of the filter, determining that the preset condition is met, and conducting the subsequent film deposition according to the determined film layer thickness compensation;
wherein the filter is composed of at least two film resonators.

5. A device for manufacturing a film resonator, comprising: a detecting component, a judging component, a processing component and a film depositing component; wherein
the device is configured to predetermine a filter structure with a plurality of film layers to be deposited and a mass loading layer to be deposited, predetermine a standard thickness range for each film layer to be deposited, predetermine a base frequency of the film resonator without the mass load layer and a target frequency of the film resonator with the mass load layer, and predetermine a target frequency offset as the base frequency to the target frequency;
the detecting component is configured to detect a thickness of each film layer which has been deposited;
the judging component is configured to, when the detected thickness of any film layer which has been deposited is not in its standard thickness range, judge whether the mass loading layer has been deposited;
the processing component is configured to, in a case that a judgement result of the judging component is that the mass loading layer has not been deposited, select for thickness compensation at least one film layer which has not been deposited from the plurality of film layers to be deposited, recalculate, in a model simulation of the filter structure, a compensated thickness of the selected at least one film layer which has not been deposited by substituting the target frequency and the thickness of the film layer which has been deposited into the model, wherein the compensated thickness is determined so that the target frequency is kept unchanged, and calculate, in a model simulation of the filter structure, a new calculated thickness of the mass loading layer required for generating the target frequency offset by substituting the compensated thickness of the selected at least one film layer which has not been deposited and the target frequency offset into the model; and
the film depositing component is configured to conduct subsequent film deposition so that the selected at least one film layer which has not been deposited is deposited with the compensated thickness and the mass loading layer is deposited with new calculated thickness of the mass loading layer.

6. The device as claimed in claim 5, wherein
the processing component is further configured to, in a case that the judgement result of the judging component is that the mass loading layer has been deposited, while keeping the base frequency unchanged, select different film layers which have not been deposited for thickness compensation, and determine a film layer thickness compensation which least affects a frequency offset;
the film depositing component is further configured to conduct subsequent film deposition according to the determined film layer thickness compensation;
wherein the processing component is configured to simulate the thickness compensation conducted for each film layer which has not been deposited, calculate the frequency offset after the thickness compensation corresponding to each film layer which has not been deposited, compare the frequency offset after the thickness compensation corresponding to each film layer which has not been deposited with the target frequency offset, and determine the film layer thickness compensation having a minimum deviation from the target frequency offset.

7. The device as claimed in claim 6, the device further comprises: an evaluating component;
the evaluating component is configured to, after determining the film layer thickness compensation which least affects the frequency offset, and before conducting the subsequent film deposition according to the determined film layer thickness compensation, evaluate the determined film layer thickness compensation, and when an evaluation result meets a preset condition, inform the film depositing component to conduct the subsequent film deposition according to the determined film layer thickness compensation.

8. The device as claimed in claim 7, wherein the evaluating component is configured to evaluate whether the minimum deviation from the target frequency offset obviously affects performance of a filter, when the minimum deviation from the target frequency offset does not obviously affect the performance of the filter, determine that the preset condition is met, and inform the film depositing component to conduct the subsequent film deposition according to the determined film layer thickness compensation; wherein the filter is composed of at least two film resonators.

## Patentansprüche

1. Verfahren zur Herstellung eines Filmresonators, umfassend:
Vorbestimmen einer Filterstruktur mit einer Vielzahl von Filmschichten, die abgeschieden werden sollen, und einer Masseladungsschicht, die abgeschieden werden soll,
Vorbestimmen eines Standarddickenbereichs für jede Filmschicht, die abgeschieden werden soll,
Vorbestimmen einer Basisfrequenz des Filmresonators ohne die Masseladungsschicht, und einer Zielfrequenz des Filmresonators mit der Masseladungsschicht,
Vorbestimmen eines Zielfrequenzversatzes als die Basisfrequenz zur Zielfrequenz,
das Verfahren weiter umfasst:
Erfassen einer Dicke jeder Filmschicht, die abgeschieden wurde;
wenn die erfasste Dicke einer Filmschicht, die abgeschieden wurde, nicht in ihrem Standarddickenbereich liegt, Beurteilen, ob die Masseladungsschicht abgeschieden wurde, und falls die Masseladungsschicht nicht abgeschieden wurde, Auswählen von mindestens einer Filmschicht, die nicht abgeschieden wurde, aus der Vielzahl von Filmschichten, die abgeschieden werden sollen, zum Dickenausgleich;
Neuberechnen, in einer Modellsimulation der Filterstruktur, einer ausgeglichenen Dicke der ausgewählten mindestens einen Filmschicht, die nicht abgeschieden wurde, durch Ersetzen der Zielfrequenz und der Dicke der Filmschicht, die abgeschieden wurde, im Modell, wobei die ausgeglichene Dicke so bestimmt wird, dass die Zielfrequenz unverändert gehalten wird;
Berechnen, in einer Modellsimulation der Filterstruktur, einer neu berechneten Dicke der Masseladungsschicht, die zum Erzeugen des Zielfrequenzversatzes erforderlich ist, durch Ersetzen der ausgeglichenen Dicke der ausgewählten mindestens einen Filmschicht, die nicht abgeschieden wurde, und des Zielfrequenzversatzes im Modell; und
Durchführen von anschließender Filmabscheidung, sodass die ausgewählte mindestens eine Filmschicht, die nicht abgeschieden wurde, mit der ausgeglichenen Dicke abgeschieden wird, und die Masseladungsschicht mit neu berechneter Dicke der Masseladungsschicht abgeschieden wird.

2. Verfahren nach Anspruch 1, wobei das Verfahren weiter umfasst:
falls die Masseladungsschicht abgeschieden wurde, Auswählen, unter Unveränderthalten der Basisfrequenz, von verschiedenen Filmschichten, die nicht abgeschieden wurden, zum Dickenausgleich, Bestimmen eines Filmschicht-Dickenausgleichs, der sich am wenigsten auf einen Frequenzversatz auswirkt, und Durchführen von anschließender Filmabscheidung gemäß dem bestimmten Filmschicht-Dickenausgleich;
wobei das Auswählen von verschiedenen Filmschichten, die nicht abgeschieden wurden, zum Dickenausgleich, und Bestimmen des Filmschicht-Dickenausgleichs, der sich am wenigsten auf den Frequenzversatz auswirkt, umfasst: Simulieren des Dickenausgleichs, der für jede Filmschicht durchgeführt wird, die nicht abgeschieden wurde; Berechnen des Frequenzversatzes nach dem Dickenausgleich, der jeder Filmschicht entspricht, die nicht abgeschieden wurde; und Vergleichen des Frequenzversatzes nach dem Dickenausgleich, der jeder Filmschicht entspricht, die nicht abgeschieden wurde, mit dem Zielfrequenzversatz, und Bestimmen des Filmschicht-Dickenausgleichs, der eine minimale Abweichung vom Zielfrequenzversatz aufweist.

3. Verfahren nach Anspruch 2, wobei nach dem Bestimmen des Filmschicht-Dickenausgleichs, der sich am wenigsten auf den Frequenzversatz auswirkt, und vor dem Durchführen der anschließenden Filmabscheidung gemäß dem bestimmten Filmschicht-Dickenausgleich das Verfahren weiter umfasst:
Evaluieren des bestimmten Filmschicht-Dickenausgleichs, und wenn ein Evaluierungsergebnis eine vorgegebene Bedingung erfüllt, Durchführen der anschließenden Filmabscheidung gemäß dem bestimmten Filmschicht-Dickenausgleich.

4. Verfahren nach Anspruch 3, wobei das Evaluieren des bestimmten Filmschicht-Dickenausgleichs, und wenn das Evaluierungsergebnis die vorgegebene Bedingung erfüllt, das Durchführen der anschließenden Filmabscheidung gemäß dem bestimmten Filmschicht-Dickenausgleich umfasst:
Evaluieren, ob sich die minimale Abweichung vom Zielfrequenzversatz offensichtlich auf Leistung eines Filters auswirkt, wenn sich die minimale Abweichung vom Zielfrequenzversatz nicht offensichtlich auf die Leistung des Filters auswirkt, Bestimmen, dass die vorgegebene Bedingung erfüllt ist, und Durchführen der anschließenden Filmabscheidung gemäß dem bestimmten Filmschicht-Dickenausgleich;
wobei das Filter aus mindestens zwei Filmresonatoren besteht.

5. Vorrichtung zur Herstellung eines Filmresonators, umfassend: eine Erfassungskomponente, eine Beurteilungskomponente, eine Verarbeitungskomponente und eine Filmabscheidungskomponente; wobei
die Vorrichtung dazu konfiguriert ist, eine Filterstruktur mit einer Vielzahl von Filmschichten, die abgeschieden werden sollen, und einer Masseladungsschicht, die abgeschieden werden soll, vorzubestimmen, einen Standarddickenbereich für jede Filmschicht, die abgeschieden werden soll, vorzubestimmen, eine Basisfrequenz des Filmresonators ohne die Masseladungsschicht und eine Zielfrequenz des Filmresonators mit der Masseladungsschicht vorzubestimmen, und einen Zielfrequenzversatz als die Basisfrequenz zur Zielfrequenz vorzubestimmen;
die Erfassungskomponente dazu konfiguriert ist, eine Dicke jeder Filmschicht, die abgeschieden wurde, zu erfassen;
die Beurteilungskomponente dazu konfiguriert ist, wenn die erfasste Dicke einer Filmschicht, die abgeschieden wurde, nicht in ihrem Standarddickenbereich liegt, zu beurteilen, ob die Masseladungsschicht abgeschieden wurde;
die Verarbeitungskomponente dazu konfiguriert ist, falls ein Beurteilungsergebnis der Beurteilungskomponente lautet, dass die Masseladungsschicht nicht abgeschieden wurde, zum Dickenausgleich mindestens eine Filmschicht, die nicht abgeschieden wurde, aus der Vielzahl von Filmschichten, die abgeschieden werden sollen, auszuwählen, in einer Modellsimulation der Filterstruktur eine ausgeglichene Dicke der ausgewählten mindestens einen Filmschicht, die nicht abgeschieden wurde, durch Ersetzen der Zielfrequenz und der Dicke der Filmschicht, die abgeschieden wurde, im Modell neu zu berechnen, wobei die ausgeglichene Dicke so bestimmt wird, dass die Zielfrequenz unverändert gehalten wird, und in einer Modellsimulation der Filterstruktur eine neu berechnete Dicke der Masseladungsschicht, die zum Erzeugen des Zielfrequenzversatzes erforderlich ist, durch Ersetzen der ausgeglichenen Dicke der ausgewählten mindestens einen Filmschicht, die nicht abgeschieden wurde, und des Zielfrequenzversatzes im Modell zu berechnen; und
die Filmabscheidungskomponente dazu konfiguriert ist, anschließende Filmabscheidung so durchzuführen, dass die ausgewählte mindestens eine Filmschicht, die nicht abgeschieden wurde, mit der ausgeglichenen Dicke abgeschieden wird, und die Masseladungsschicht mit neu berechneter Dicke der Masseladungsschicht abgeschieden wird.

6. Vorrichtung nach Anspruch 5, wobei
die Verarbeitungskomponente weiter dazu konfiguriert ist, falls das Beurteilungsergebnis der Beurteilungskomponente lautet, dass die Masseladungsschicht abgeschieden wurde, unter Unveränderthalten der Basisfrequenz verschiedene Filmschichten, die nicht abgeschieden wurden, zum Dickenausgleich auszuwählen und einen Filmschicht-Dickenausgleich zu bestimmen, der sich am wenigsten auf einen Frequenzversatz auswirkt;
die Filmabscheidungskomponente weiter dazu konfiguriert ist, anschließende Filmabscheidung gemäß dem bestimmten Filmschicht-Dickenausgleich durchzuführen;
wobei die Verarbeitungskomponente dazu konfiguriert ist, den Dickenausgleich, der für jede Filmschicht, die nicht abgeschieden wurde, durchgeführt wird, zu simulieren, den Frequenzversatz nach dem Dickenausgleich, der jeder Filmschicht entspricht, die nicht abgeschieden wurde, zu berechnen, den Frequenzversatz nach dem Dickenausgleich, der jeder Filmschicht entspricht, die nicht abgeschieden wurde, mit dem Zielfrequenzversatz zu vergleichen, und den Filmschicht-Dickenausgleich zu bestimmen, der eine minimale Abweichung vom Zielfrequenzversatz aufweist.

7. Vorrichtung nach Anspruch 6, die Vorrichtung weiter umfasst: eine Evaluierungskomponente;
die Evaluierungskomponente dazu konfiguriert ist, nach dem Bestimmen des Filmschicht-Dickenausgleichs, der sich am wenigsten auf den Frequenzversatz auswirkt, und vor dem Durchführen der anschließenden Filmabscheidung gemäß dem bestimmten Filmschicht-Dickenausgleich den bestimmten Filmschicht-Dickenausgleich zu evaluieren, und wenn ein Evaluierungsergebnis eine vorgegebene Bedingung erfüllt, die Filmabscheidungskomponente zu informieren, die anschließende Filmabscheidung gemäß dem bestimmten Filmschicht-Dickenausgleich durchzuführen.

8. Vorrichtung nach Anspruch 7, wobei die Evaluierungskomponente dazu konfiguriert ist, zu evaluieren, ob sich die minimale Abweichung vom Zielfrequenzversatz offensichtlich auf Leistung eines Filters auswirkt, wenn sich die minimale Abweichung vom Zielfrequenzversatz nicht offensichtlich auf die Leistung des Filters auswirkt, zu bestimmen, dass die vorgegebene Bedingung erfüllt ist, und die Filmabscheidungskomponente zu informieren, die anschließende Filmabscheidung gemäß dem bestimmten Filmschicht-Dickenausgleich durchzuführen; wobei das Filter aus mindestens zwei Filmresonatoren besteht.

## Revendications

1. Procédé de fabrication d'un résonateur à film, comprenant :
la prédétermination d'une structure de filtre avec une pluralité de couches de film à déposer et une couche de chargement massique à déposer,
la prédétermination d'une plage d'épaisseur standard pour chaque couche de film à déposer,
la prédétermination d'une fréquence de base du résonateur à film sans la couche de charge massique et d'une fréquence cible du résonateur à film avec la couche de charge massique,
la prédétermination d'un décalage de fréquence cible en tant que fréquence de base à la fréquence cible,
le procédé comprend en outre :
la détection d'une épaisseur de chaque couche de film qui a été déposée ;
lorsque l'épaisseur détectée de toute couche de film qui a été déposée n'est pas dans sa plage d'épaisseur standard, le fait de juger si la couche de chargement massique a été déposée, et dans un cas où la couche de chargement massique n'a pas été déposée, la sélection d'une compensation d'épaisseur d'au moins une couche de film qui n'a pas été déposée à partir de la pluralité de couches de film à déposer ;
le recalcul, dans une simulation de modèle de la structure de filtre, d'une épaisseur compensée de l'au moins une couche de film sélectionnée qui n'a pas été déposée en remplaçant la fréquence cible et l'épaisseur de la couche de film qui a été déposée dans le modèle, dans lequel l'épaisseur compensée est déterminée de sorte que la fréquence cible reste inchangée ;
le calcul, dans une simulation de modèle de la structure de filtre, d'une nouvelle épaisseur calculée de la couche de chargement massique requise pour générer le décalage de fréquence cible en remplaçant l'épaisseur compensée de l'au moins une couche de film sélectionnée qui n'a pas été déposée et le décalage de fréquence cible dans le modèle ; et
la mise en oeuvre d'un dépôt de film ultérieur de sorte que l'au moins une couche de film sélectionnée qui n'a pas été déposée soit déposée avec l'épaisseur compensée et que la couche de chargement massique soit déposée avec la nouvelle épaisseur calculée de la couche de chargement massique.

2. Procédé selon la revendication 1, le procédé comprenant en outre :
dans un cas où la couche de chargement massique a été déposée, tout en gardant la fréquence de base inchangée, la sélection de différentes couches de film qui n'ont pas été déposées pour une compensation d'épaisseur, la détermination d'une compensation d'épaisseur de couche de film qui affecte le moins un décalage de fréquence, et la mise en oeuvre d'un dépôt de film ultérieur selon la compensation d'épaisseur de couche de film déterminée ;
dans lequel la sélection de différentes couches de film qui n'ont pas été déposées pour une compensation d'épaisseur, et la détermination de la compensation d'épaisseur de couche de film qui affecte le moins le décalage de fréquence comprennent : la simulation de la compensation d'épaisseur mise en oeuvre pour chaque couche de film qui n'a pas été déposée ; le calcul du décalage de fréquence après la compensation d'épaisseur correspondant à chaque couche de film qui n'a pas été déposée ; et la comparaison du décalage de fréquence après la compensation d'épaisseur correspondant à chaque couche de film qui n'a pas été déposée avec le décalage de fréquence cible, et la détermination de la compensation d'épaisseur de couche de film ayant un écart minimal par rapport au décalage de fréquence cible.

3. Procédé selon la revendication 2, dans lequel après détermination de la compensation d'épaisseur de couche de film qui affecte le moins le décalage de fréquence, et avant la mise en oeuvre du dépôt de film ultérieur selon la compensation d'épaisseur de couche de film déterminée, le procédé comprend en outre :
l'évaluation de la compensation d'épaisseur de couche de film déterminée, et lorsqu'un résultat d'évaluation satisfait une condition prédéfinie, la mise en oeuvre du dépôt de film ultérieur selon la compensation d'épaisseur de couche de film déterminée.

4. Procédé selon la revendication 3, dans lequel l'évaluation de la compensation d'épaisseur de couche de film déterminée, et, lorsque le résultat d'évaluation satisfait la condition prédéfinie, la mise en oeuvre du dépôt de film ultérieur selon la compensation d'épaisseur de couche de film déterminée comprennent :
le fait d'évaluer si l'écart minimal par rapport au décalage de fréquence cible affecte de façon évidente la performance d'un filtre, lorsque l'écart minimal par rapport au décalage de fréquence cible n'affecte pas de façon évidente la performance du filtre, le fait de déterminer que la condition prédéfinie est satisfaite, et la mise en oeuvre du dépôt de film ultérieur selon la compensation d'épaisseur de couche de film déterminée ;
dans lequel le filtre est composé d'au moins deux résonateurs à film.

5. Dispositif de fabrication d'un résonateur à film, comprenant : un composant de détection, un composant de jugement, un composant de traitement et un composant de dépôt de film ; dans lequel
le dispositif est configuré pour prédéterminer une structure de filtre avec une pluralité de couches de film à déposer et une couche de chargement massique à déposer, prédéterminer une plage d'épaisseur standard pour chaque couche de film à déposer, prédéterminer une fréquence de base du résonateur à film sans la couche de charge massique et une fréquence cible du résonateur à film avec la couche de charge massique, et prédéterminer un décalage de fréquence cible en tant que fréquence de base à la fréquence cible ;
le composant de détection est configuré pour détecter une épaisseur de chaque couche de film qui a été déposée ;
le composant de jugement est configuré pour, lorsque l'épaisseur détectée de toute couche de film qui a été déposée n'est pas dans sa plage d'épaisseur standard, juger si la couche de chargement massique a été déposée ;
le composant de traitement est configuré pour, dans un cas où un résultat de jugement du composant de jugement est que la couche de chargement massique n'a pas été déposée, sélectionner une compensation d'épaisseur d'au moins une couche de film qui n'a pas été déposée à partir de la pluralité de couches de film à déposer, recalculer, dans une simulation de modèle de la structure de filtre, une épaisseur compensée de l'au moins une couche de film sélectionnée qui n'a pas été déposée en remplaçant la fréquence cible et l'épaisseur de la couche de film qui a été déposée dans le modèle, dans lequel l'épaisseur compensée est déterminée de sorte que la fréquence cible reste inchangée, et calculer, dans une simulation de modèle de la structure de filtre, une nouvelle épaisseur calculée de la couche de chargement massique requise pour générer le décalage de fréquence cible en remplaçant l'épaisseur compensée de l'au moins une couche de film sélectionnée qui n'a pas été déposée et le décalage de fréquence cible dans le modèle ; et
le composant de dépôt de film est configuré pour mettre en oeuvre un dépôt de film ultérieur de sorte que l'au moins une couche de film sélectionnée qui n'a pas été déposée soit déposée avec l'épaisseur compensée et la couche de chargement massique est déposée avec une nouvelle épaisseur calculée de la couche de chargement massique.

6. Dispositif selon la revendication 5, dans lequel
le composant de traitement est en outre configuré pour, dans un cas où le résultat de jugement du composant de jugement est que la couche de chargement massique a été déposée, tout en gardant la fréquence de base inchangée, sélectionner différentes couches de film qui n'ont pas été déposées pour une compensation d'épaisseur, et déterminer une compensation d'épaisseur de couche de film qui affecte le moins un décalage de fréquence ;
le composant de dépôt de film est en outre configuré pour mettre en oeuvre un dépôt de film ultérieur selon la compensation d'épaisseur de couche de film déterminée ;
dans lequel le composant de traitement est configuré pour simuler la compensation d'épaisseur mise en oeuvre pour chaque couche de film qui n'a pas été déposée, calculer le décalage de fréquence après la compensation d'épaisseur correspondant à chaque couche de film qui n'a pas été déposée, comparer le décalage de fréquence après la compensation d'épaisseur correspondant à chaque couche de film qui n'a pas été déposée avec le décalage de fréquence cible, et déterminer la compensation d'épaisseur de couche de film ayant un écart minimal par rapport au décalage de fréquence cible.

7. Dispositif selon la revendication 6, le dispositif comprend en outre : un composant d'évaluation ;
le composant d'évaluation est configuré pour, après détermination de la compensation d'épaisseur de couche de film qui affecte le moins le décalage de fréquence, et avant mise en oeuvre du dépôt de film ultérieur selon la compensation d'épaisseur de couche de film déterminée, évaluer la compensation d'épaisseur de couche de film déterminée, et lorsqu'un résultat d'évaluation satisfait une condition prédéfinie, indiquer au composant de dépôt de film de mettre en oeuvre le dépôt de film ultérieur selon la compensation d'épaisseur de couche de film déterminée.

8. Dispositif selon la revendication 7, dans lequel le composant d'évaluation est configuré pour évaluer si l'écart minimal par rapport au décalage de fréquence cible affecte de façon évidente la performance d'un filtre, lorsque l'écart minimal par rapport au décalage de fréquence cible n'affecte pas de façon évidente la performance du filtre, déterminer que la condition prédéfinie est satisfaite, et indiquer au composant de dépôt de film de mettre en oeuvre le dépôt de film ultérieur selon la compensation d'épaisseur de couche de film déterminée ; dans lequel le filtre est composé d'au moins deux résonateurs à film.
